# EUROPÄISCHE PATENTSCHRIFT

(11) **EP 1 478 092 B1**
(45) Veröffentlichungstag und Bekanntmachung des Hinweises auf die Patenterteilung: **14.11.2007**
(21) Anmeldenummer: 03010817.9
(22) Anmeldetag: 14.05.2003
(51) Int. Cl.: H03K 21/10, H03K 21/40, G06F 1/14, G06F 9/46

(54) **Digitaler Zähler**
Digital counter
Compteur numérique

(43) Veröffentlichungstag der Anmeldung: 17.11.2004
(73) Patentinhaber: Tektronix International Sales GmbH, 8212 Neuhausen (CH)
(72) Erfinder: Galuschka, Holger, 12047 Berlin (DE)
(74) Vertreter: Schurack, Eduard F.

(56) Entgegenhaltungen:
- DE-A- 19 858 536
- US-A- 4 086 470
- US-A- 4 151 403
- US-A- 4 566 069
- US-A- 5 572 720
- US-A- 5 826 066

## Beschreibung

Die vorliegende Erfindung betrifft einen digitalen Zähler, wobei sich der Zählerstand zusammensetzt aus einem Hardwareanteil, der die n niedrigstwertigen Bits des Zählerstands bestimmt, und mindestens einem Softwareanteil, der die restlichen höherwertigen Bits des Zählerstands bestimmt. Sie betrifft überdies ein Verfahren zum Betreiben eines derartigen digitalen Zählers.

Derartige Zähler sind bekannt, wobei der Hardwareanteil häufig unter Verwendung von Flip-Flops realisiert wird. Derartige Zähler werden beispielsweise dazu verwendet, um bei Einrichtungen zum Monitoren von Telekommunikationsverbindungen Zeitstempel zu vergeben. Als Zeitstempel wird der entsprechende Zählerstand verwendet. Um den Aufwand gering zu halten, wird der Hardwareanteil gewöhnlich als 16- bis 32-Bit-Zähler realisiert. Bei einem Überlauf wird der Softwareanteil um 1 höhergezählt. Hierbei ist zu berücksichtigen, dass ein Überlauf des Hardwareanteils einen Interrupt auslöst und ein Interrupt-Server jedoch nicht beliebig schnell ist. Im Bereich des Hardwareanteilüberlaufs besteht daher eine gewisse Totzeit. Beispielsweise ist eine Situation denkbar, in der der Hardwareanteil schon wieder auf 0000... steht, der Softwareanteil jedoch noch nicht hochgezählt hat. Würde man für einen Zeitstempel dieses Datum wählen, würde die Uhr quasi rückwärts zählen. Das Ergebnis wäre folglich falsch.

Um dies zu verhindern, wird sicherheitshalber der Hardwareanteil des Zählers zweimal gelesen, damit die Zuordnung von niederwertigen und höherwertigen Bits korrekt erfolgen kann. Falls der zweite Wert kleiner als der zuerst gelesene Wert ist, hat demnach ein Überlauf stattgefunden. Der sich aus dem Softwareanteil und dem zweiten gelesenen Hardware- und Softwareanteil ergebende Zählerstand ist demnach der richtige.

Diese Lösung ist jedoch in den Fällen nicht verwendbar, bei denen ein Prozessor nur einen Interrupt pro Zeit verarbeiten kann. Es können Situationen auftreten, in denen der Prozessor einen Interrupt vom Überlauf des Hardwareanteils erhält und gleichzeitig einen Interrupt von dem Ereignis, das mit einem Zeitstempel versehen werden soll. Der Prozessor ist bis zur Abarbeitung des ersten Interrupts blockiert und weist dem Ereignis einen falschen Zeitstempel zu. Selbst bei Vergabe unterschiedlicher Interruptprioritäten kann dieses Problem nicht gelöst werden, da entweder der Zeitstempel falsch berechnet wird oder der Eingang des Ereignisses einem falschen Zeitpunkt zugeordnet wird.

Aus der US 4,151,403 ist ein optischer Codierer bekannt, welcher eine Kette von digitalen Pulsen als Funktion einer Länge eines Endlosmaterials pro Umdrehung beim Abwickeln des Materials von einer Rolle erzeugt. Ein Zähler zählt die Pulse des Codierers für jede Umdrehung der Rolle. Der Zähler weist eine adressierbare Hardwarezählerkette allein oder in Verbindung mit einem Speicher auf, welcher die Anzahl der Überläufe der Zählerkette zählt.

Des Weiteren ist aus der DE 198 58 536 A1 ein Verfahren zur Signalauswertung bekannt, bei dem zwei zusätzlich benötigte Bits eines 16-Bit-Timers durch einen Softwareanteil realisiert werden. Mittels dem Verfahren wird die Geschwindigkeit eines Fahrzeugrades bestimmt. Die Ermittlung der Geschwindigkeit wird dabei aus der Differenz eines letzten Timerwertes und eines drittletzten Timerwertes ermittelt, wobei dazu alle drei Überläufe der Timerwertdifferenzen exakt erfasst werden müssen. Als Überlaufzähler werden drei Bits in einem Trommelspeicher herangezogen, welcher als viertes Bit ein Verdachtsbit aufweist. Aufgrund einer kurzen Zykluszeit ist dieses Verdachtsbit erforderlich, da ansonsten ein Überlauf verpasst werden könnte, da die alten Zählerwerte nicht zwischengespeichert werden.

Des Weiteren ist aus der Druckschrift US 5,572,720 eine Zeitgebereinheit in einem Mikroprozessor bekannt, welche einen Hardwaretimer mit einem ersten Register mit einer festen Kapazität aufweist. Erfolgt eine überlappende Eingabe in das erste Register und wird dies registriert, wird der Hardwarezeitgeber durch einen Softwareanteil dadurch erweitert, dass ein zweites Register für jede derartige überlappende Eingabe inkrementiert wird und überprüft wird, ob die beiden Register während der Zeitdauer der überlappenden Eingabe und der Inkrementierung kohärent sind.

Die Aufgabe der vorliegenden Erfindung besteht deshalb darin, dieses sich mit einem gattungsgemäßen Zähler ergebende Problem zu beseitigen. Aufgabe der Erfindung ist es auch, ein entsprechendes Verfahren zum Betreiben eines digitalen Zählers bereitzustellen, das dieses Problem beseitigt.

Diese Aufgaben werden gelöst durch einen digitalen Zähler mit den Merkmalen von Patentanspruch 1 sowie ein Verfahren zum Betreiben eines digitalen Zählers mit den Merkmalen von Patentanspruch 5.

Der Erfindung liegt die Erkenntnis zugrunde, dass das zeitkritische Aufeinandertreffen zweier Interrupts verhindert werden kann, wenn der Softwareanteil zweimal ausgeführt wird, wobei der jeweilige Softwareanteil zu einem zeitunkritischen Zeitpunkt umgestellt wird, so dass bei Überlauf des Hardwareanteils des Zählers der bereits umgestellte, zu diesem Zeitpunkt gültige Softwareanteil zu lesen ist. Da das Umstellen des jeweils gültigen Softwareanteils nicht mehr zeitlich zusammenfällt mit dem Überlauf des Hardwareanteils des Zählers, können die aus dem Stand der Technik bekannten Probleme zuverlässig verhindert werden.

Die Realisierung zeichnet sich dadurch aus, dass der maximale Zählerstand des Hardwareanteils mit einem Maximalwert korelliert ist und der erste Zählbereich des Hardwareanteils im Wesentlichen zwischen den Zählerständen 0 und der Hälfte des Maximalwerts des Hardwareanteils minus 1 und der zweite Zählbereich im Wesentlichen zwischen den Zählerständen der Hälfte des Maximalwerts bis Maximalwert des Hardwareanteils minus 1 definiert ist.

Bei einem Hardwareanteil mit 4 Bit geht daher der erste Bereich von 0 bis 7, der zweite Bereich von 8 bis 15. Der Maximalwert im Sinne der Erfindung ist demnach 16. Bei einem Dezimalsystem wäre der erste Bereich von 0 bis 4, der zweite Bereich von 5 bis 9, der sogenannte Maximalwert 10. Maximalwert im Sinne der vorliegenden Erfindung bezeichnet also die Anzahl unterschiedlicher Werte, die in dem jeweiligen System möglich sind: Im Dezimalsystem beispielsweise 10, mit 4 Bits beispielsweise 16.

Selbstverständlich kann das erfindungsgemäße Ergebnis auch erzielt werden, wenn geringfügig andere Definitionen gewählt werden, wie für den Fachmann offensichtlich. Wesentlich ist, dass die Zeiträume, in denen der jeweilige Softwareanteil gelesen wird, sich nicht überlappen mit dem Zeitpunkt, in dem der jeweilige Softwareanteil verändert wird.

Bevorzugt umfasst daher ein erfindungsgemäßer digitaler Zähler eine Softwareanteil-Erhöhungsvorrichtung, die ausgelegt ist, den ersten und den zweiten Softwareanteil bei vorgebbaren Werten des Hardwareanteils zu verändern, insbesondere um den Wert 1 zu erhöhen. Sofern ein Softwareanteil um 1 erhöht wurde, kann der andere anstelle einer Erhöhung um 1 zu dem Zeitpunkt, in dem seine nächste Veränderung ansteht, dem zuerst geänderten Softwareanteil gleichgesetzt werden.

Unkritische Zeitpunkte zur Erhöhung des zweiten Softwareanteils liegen bei einem Hardwareanteil, der zwischen 10 und 40 Prozent des Maximalwerts, bevorzugt 25 Prozent des Maximalwerts beträgt. Für den ersten Softwareanteil gilt entsprechend ein Hardwareanteil zwischen 60 und 90 Prozent des Maximalwerts, bevorzugt 75 Prozent des Maximalwerts.

Besonders geschickt trägt die vorliegende Erfindung dem Umstand Rechnung, dass häufig eine Normierung des Zählerstands auf einem anderen Maximalwert erwünscht ist, als vom installierten Hardwareanteil des Zählers vorgegeben. Insbesondere lässt sich durch eine Umnormierung auf einen anderen Maximalwert oft eine leichtere Interpretation der vergebenen Zeitstempel erreichen.

Beispielsweise arbeitet der Hardwareanteil mit einem Maximalwert von 24.576.000. Erwünscht sei jedoch eine Normierung auf einen Maximalwert von 2.000.000. Bei der erfindungsgemäßen Lösung lässt sich dies dadurch erreichen, dass der auf den zweiten Maximalwert normierte Zählerstand zusammengesetzt wird aus einem auf den zweiten Maximalwert normierten Softwareanteil und einem auf den zweiten Maximalwert normierten Hardwareanteil.

Der Softwareanteil wird nunmehr so ausgelegt, dass er ebenfalls die n niedrigstwertigen Bits umfasst, und zwar durch Linksverschiebung des ursprünglichen Softwareanteils. Die Linksverschiebung entspricht einer Multiplikation mit dem ersten Maximalwert. Da für die Umnormierung auch eine Division mit dem ersten Maximalwert nötig ist, heben sich diese beiden Vorgänge auf. Aus der Umnormierung verbleibt ein Faktor, der dem zweiten Maximalwert entspricht. Diese auf den zweiten Maximalwert normierten Werte für die Softwareanteile werden bevorzugt abgespeichert, so dass sie für Addierungen innerhalb des jeweiligen Zeitraums verwendet werden können, ohne dass sie erneut berechnet werden müssten.

Der auf den zweiten Maximalwert normierte Hardwareanteil wird bevorzugt durch folgenden Schritt berechnet: Multiplikation mit dem zweiten Maximalwert und Division durch den ersten Maximalwert, oder umgekehrt.

Das Zusammensetzen des jeweiligen Softwareanteils und des jeweiligen Hardwareanteils kann nach dem oben erwähnten Multiplikationsschritt des jeweils gültigen Softwareanteils mit dem zweiten Maximalwert auf einfache Weise dadurch erreicht werden, dass der auf den zweiten Maximalwert normierte Softwareanteil und der auf den zweiten Maximalwert normierte Hardwareanteil addiert werden.

Bevorzugt wird der oben erwähnte Multiplikationsschritt in dem der jeweils gültige Softwareanteil mit dem zweiten Maximalwert multipliziert wird, zu einem rechenzeitunkritischen Zeitpunkt durchgeführt. Bevorzugt wird eine Berechnung des auf den zweiten Maximalwert normierten zweiten Softwareanteils bei einem Wert zwischen 10 und 40 Prozent des ersten Maximalwerts des Hardwareanteils, insbesondere bei 25 Prozent des ersten Maximalwerts des Hardwareanteils, durchgeführt und die Berechnung des auf den zweiten Maximalwert normierten ersten Softwareanteils bei einem Wert zwischen 60 und 90 Prozent des ersten Maximalwerts des Hardwareanteils, insbesondere bei 75 Prozent des ersten Maximalwerts des Hardwareanteils.

Weitere vorteilhafte Ausführungsformen ergeben sich aus den Unteransprüchen.

Im Nachfolgenden wird nunmehr ein Ausführungsbeispiel der vorliegenden Erfindung mit Bezug auf die beigefügten Zeichnungen näher beschrieben. Es zeigen:
- Figur 1: in schematischer Darstellung den Hardwareanteil sowie die beiden Softwareanteile einer ersten Ausführungsform eines erfindungsgemäßen Zählers;
- Figur 2: in schematischer Darstellung die beiden Softwareanteile und den Hardwareanteil einer zweiten Ausführungsform eines erfindungsgemäßen Zählers;
- Figur 3: in schematischer Darstellung den Gültigkeitsbereich des jeweiligen Softwareanteils an einem einfachen Ausführungsbeispiel und den bevorzugten Zeitpunkt zum Ändern des jeweiligen Softwareanteils; und
- Figur 4: Erläuterungen zur Umnormierung eines erfindungsgemäßen digitalen Zählers.

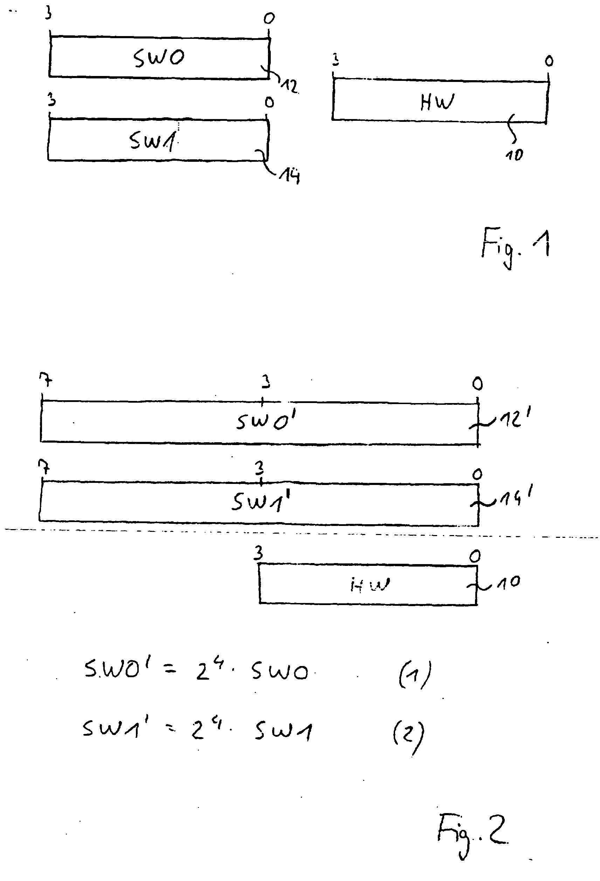

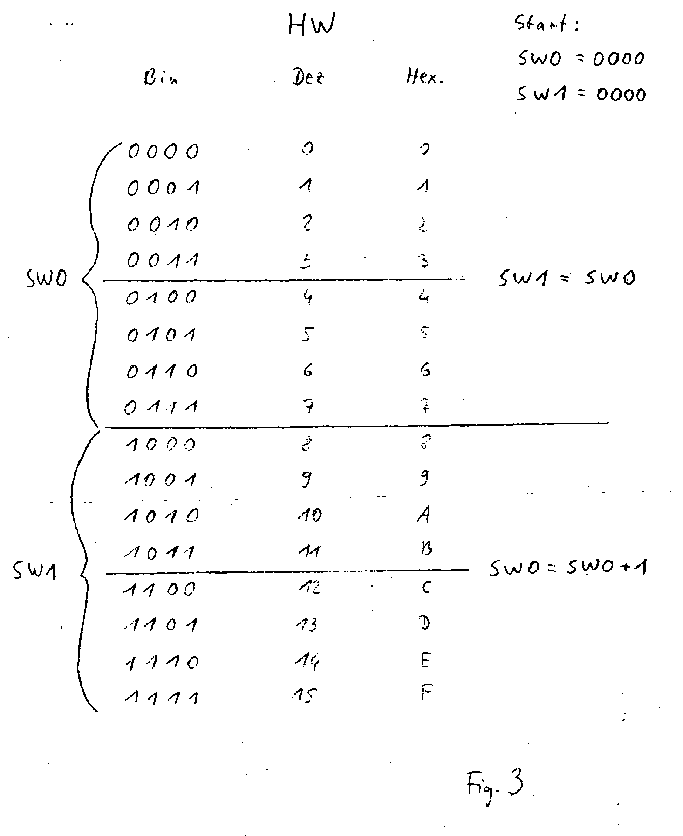

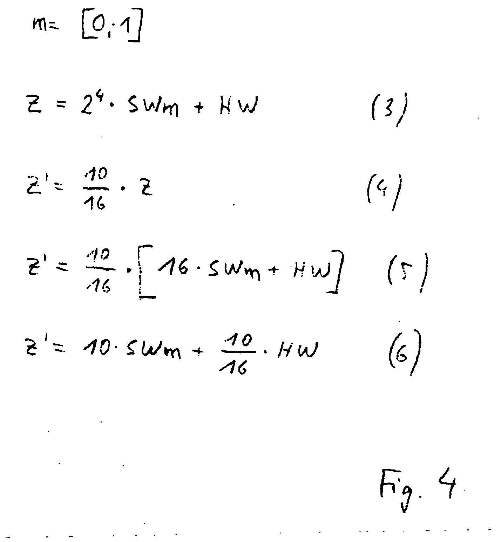

Figur 1 zeigt in schematischer Darstellung wie sich der tatsächliche Zählerstand bei einer ersten Ausführungsform des digitalen Zählers gemäß der vorliegenden Erfindung zusammensetzt. Demnach werden die vier niedrigstwertigen Bits vom Hardwareanteil 10 bestimmt, während die vier restlichen Bits entweder von einem ersten Softwareanteil 12 oder von einem zweiten Softwareanteil 14 bestimmt werden.

Figur 3 zeigt an einem einfachen Ausführungsbeispiel - der Hardwareanteil sowie die Softwareanteile haben jeweils 4 Bits - den Gültigkeitsbereich des jeweiligen Softwareanteils 12, 14 sowie die bevorzugten Zeitpunkte zum Verändern des jeweiligen Softwareanteils. Sowohl der Softwareanteil 12, SW0, als auch der Softwareanteil 14, SW1, beginnen beim Wert 0, das heißt alle vier Bits sind Nullen. Gemäß der Figur wird der Softwareanteil 12, SW0, mit dem Hardwareanteil 10 verknüpft für (in dezimaler Schreibweise) die Werte 0 bis 7 des Hardwareanteils. Der Softwareanteil 14, SW1, wird mit dem Hardwareanteil verknüpft für die Werte 8 bis 15 des Hardwareanteils 10. Der Softwareanteil 14, SW1, wird bevorzugt zwischen den Werten 3 und 4 des Hardwareanteils 10 verändert, das heißt entweder um 1 hochgezählt oder gleich dem Softwareanteil 12, SW0, gesetzt. Der Softwareanteil 12, SW0, wird zwischen den Dezimalwerten 11 und 12 des Hardwareanteils 10 um 1 erhöht. Wie die Darstellung von Figur 3 erkennen lässt, wird demnach der Softwareanteil 14, SW1, zu einem Zeitpunkt geändert, in dem der Hardwareanteil 10 mit dem Softwareanteil 12, SW0, zur Gesamtanzeige des digitalen Zählers verknüpft wird, während der Softwareanteil 12, SW0, um 1 erhöht wird, wenn der Hardwareanteil 10 mit dem Softwareanteil 14, SW1, verknüpft wird. Damit sind die Zeitpunkte zum Verändern der Softwareanteile losgelöst von dem Zeitpunkt des Überlaufs des Hardwareanteils 10.

Während bei der Ausführungsform gemäß Figur 1 Softwareanteil und Hardwareanteil aneinander gereiht werden, so dass der Hardwareanteil 10 die niedrigstwertigen Bits bestimmt und der jeweils gültige Softwareanteil die restlichen höherwertigen Bits, ist in Figur 2 eine Ausführungsform dargestellt, bei der der Zählerstand durch Addition des Hardwareanteils mit dem jeweils gültigen Softwareanteil SW0', SW1' erhalten wird. Hierbei entsteht der Softwareanteil 12', SW0' durch Linksverschiebung des Softwareanteiles 12 um so viele Bits, wie der Hardwareanteil 10 umfasst, vorliegend um 4 Stellen. Dies entspricht einer Multiplikation mit 2⁴ = 16. Entsprechendes gilt für den Softwareanteil 14', SW1', der durch entsprechende Linksverschiebung aus dem Softwareanteil 14, SW1, erhalten wird. Siehe hierzu die Gleichungen (1) und (2) in Figur 2.

Der aktuelle Zählerstand ergibt sich dann durch Addition des Hardwareanteils 10 mit dem jeweils gültigen Softwareanteil 12', SW0', oder 14', SW1'.

Figur 4 zeigt die Umnormierung und ihre besonders geschickte Realisierung. Angenommen wird, dass, wie in den Figuren 1, 2 und 3 gezeigt, der Hardwareanteil sechzehn Werte annehmen kann, und nunmehr diese Zählung ins Dezimalsystem umnormiert werden soll.

Für m = 0 oder 1 hält man den Zählerstand Z gemäß Gleichung (3) in Figur 4 zu 2⁴ • SWm + HW. Der auf das Dezimalsystem normierte Zählerstand Z' ergibt daraus durch Multiplikation mit 10 und Division durch 16, siehe Gleichung (4) in Figur 4. Setzt man Gleichung (3) in Gleichung (4) ein, so ergibt sich Gleichung (5), die sich nach Kürzen der Zahl 16 im ersten Term umformulieren lässt in Gleichung (6).

In Gleichung (6) kann der erste Term, der nur zweimal im Wertebereich des Hardwareanteils 10 wechselt, zu zeitunkritischen Zeitpunkten berechnet werden. Der zweite Term in Gleichung (6) ist nur 4 Bits breit, so dass die darauf durchzuführende Multiplikation und Division bei vergleichsweise geringem Zeit- und Rechenaufwand vorgenommen werden kann. Im Gegenzug hierzu müsste bei Lösung des Ausdrucks in der eckigen Klammer von Gleichung (5) und anschließender Multiplikation und Division ein Wert mit der doppelten Anzahl von Bits multipliziert und dividiert werden.

## Patentansprüche

1. Digitaler Zähler, wobei sich der Zählerstand zusammensetzt aus einem Hardwareanteil, der die n niedrigstwertigen Bits des Zählerstands bestimmt, und mindestens einem Softwareanteil, der die restlichen höherwertigen Bits des Zählerstands bestimmt,
**dadurch gekennzeichnet,**
**dass** der Zähler einen ersten und einen zweiten Softwareanteil (12, 14) umfasst; und der Zählerstand aus dem ersten Softwareanteil (12) und dem Hardwareanteil (10) zusammengesetzt ist, wenn sich der Hardwareanteil (10) in einem ersten Zählbereich befindet, und der Zählerstand aus dem zweiten Softwareanteil (14) und dem Hardwareanteil (10) zusammengesetzt ist, wenn sich der Hardwareanteil (10) in einem zweiten Zählbereich befindet, wobei der maximale Zählerstand des Hardwareanteils (10) durch einen Maximalwert definiert ist und der erste Zählbereich des Hardwareanteils (10) im Wesentlichen zwischen den Zählerständen 0 und der Hälfte des Maximalwerts des Hardwareanteils (10) minus 1 und der zweite Zählbereich im Wesentlichen zwischen den Zählerständen der Hälfte des Maximalwerts und dem Maximalwert des Hardwareanteils (10) minus 1 definiert ist und die Veränderung des jeweiligen Softwareanteils (12, 14) vom Überlauf des Hardwareanteils (10) zeitlich separiert ist.

2. Zähler nach Anspruch 1,
**dadurch gekennzeichnet,**
**dass** er eine Softwareanteil-Erhöhungsvorrichtung umfasst, die ausgelegt ist, den ersten und den zweiten Softwareanteil (12, 14) bei vorgebbaren Werten des Hardwareanteils (10) zu verändern, insbesondere um den Wert 1 zu erhöhen.

3. Zähler nach Anspruch 2,
**dadurch gekennzeichnet,**
**dass** der vorgebbare Wert des Hardwareanteils (10) zur Erhöhung des zweiten Softwareanteils (14) zwischen 10 und 40 Prozent des Maximalwerts, bevorzugt 25 Prozent des Maximalwerts beträgt.

4. Zähler nach einem der Ansprüche 2 oder 3,
**dadurch gekennzeichnet,**
**dass** der vorgebbare Wert des Hardwareanteils (10) zur Erhöhung des ersten Softwareanteils (12) zwischen 60 und 90 Prozent des Maximalwerts, bevorzugt 75 Prozent des Maximalwerts beträgt.

5. Verfahren zum Betreiben eines digitalen Zählers, wobei sich der Zählerstand zusammensetzt aus einem Hardwareanteil (10), der die n niedrigstwertigen Bits des Zählerstands bestimmt, und mindestens einem Softwareanteil, der die restlichen höherwertigen Bits des Zählerstands bestimmt, wobei der Zähler einen ersten und einen zweiten Softwareanteil (12, 14) umfasst und der Zählerstand aus dem ersten Softwareanteil (12) und dem Hardwareanteil (10) zusammengesetzt wird, wenn sich der Hardwareanteil (10) in einem ersten Zählbereich befindet, und der Zählerstand aus dem zweiten Softwareanteil (14) und dem Hardwareanteil (10) zusammengesetzt wird, wenn sich der Hardwareanteil (10) in einem zweiten Zählbereich befindet, wobei der maximale Zählerstand des Hardwareanteils (10) durch einen Maximalwert definiert wird und der erste Zählbereich des Hardwareanteils (10) im Wesentlichen zwischen den Zählerständen 0 und der Hälfte des Maximalwerts des Hardwareanteils (10) minus 1 und der zweite Zählbereich im Wesentlichen zwischen den Zählerständen der Hälfte des Maximalwerts und dem Maximalwert des Hardwareanteils (10) minus 1 definiert wird und die Veränderung des jeweiligen Softwareanteils (12, 14) vom Überlauf des Hardwareanteils (10) zeitlich separiert wird.

6. Verfahren nach Anspruch 5,
**dadurch gekennzeichnet,**
**dass** der erste Softwareanteil (12) und der zweite Softwareanteil (14) bei vorgebbaren Werten des Hardwareanteils (10) verändert werden, insbesondere um den Wert 1 erhöht werden.

7. Verfahren nach Anspruch 6,
**dadurch gekennzeichnet,**
**dass** der zweite Softwareanteil (14) bei einem Wert zwischen 10 und 40 Prozent des Maximalwerts des Hardwareanteils (10), insbesondere bei 25 Prozent des Maximalwerts des Hardwareanteils (10), verändert wird.

8. Verfahren nach Anspruch 6,
**dadurch gekennzeichnet,**
**dass** der erste Softwareanteil (12) bei einem Wert zwischen 60 und 90 Prozent des Maximalwerts des Hardwareanteils (10), insbesondere bei 75 Prozent des Maximalwerts des Hardwareanteils (10), verändert wird.

9. Verfahren nach einem der Ansprüche 5 bis 8,
**dadurch gekennzeichnet,**
**dass** der Hardwareanteil (10) auf einen ersten Maximalwert normiert ist und zur Normierung des gesamten Zählerstands auf einen zweiten, davon unterschiedlichen Maximalwert der auf den zweiten Maximalwert normierte Zählerstand zusammengesetzt wird aus einem auf den zweiten Maximalwert normierten Softwareanteil und einem auf den zweiten Maximalwert normierten Hardwareanteil.

10. Verfahren nach Anspruch 9,
**dadurch gekennzeichnet,**
**dass** der auf den zweiten Maximalwert normierte Softwareanteil berechnet wird durch folgenden Schritt:
a1) Multiplizieren des jeweils gültigen Softwareanteils mit dem zweiten Maximalwert.

11. Verfahren nach Anspruch 10,
**dadurch gekennzeichnet,**
**dass** die auf den zweiten Maximalwert normierten Werte für die Softwareanteile abgespeichert werden, so dass sie für Addierungen innerhalb des jeweiligen Zeitraums verwendet werden können.

12. Verfahren nach einem der Ansprüche 9 bis 11,
**dadurch gekennzeichnet,**
**dass** der auf den zweiten Maximalwert normierte Hardwareanteil (10) berechnet wird durch folgenden Schritt: b1) Multiplikation mit dem zweiten Maximalwert und Division durch den ersten Maximalwert, oder umgekehrt.

13. Verfahren nach einem der Ansprüche 9 bis 12,
**dadurch gekennzeichnet,**
**dass** zur Berechnung des auf den zweiten Maximalwert normierten Zählerstands der auf den zweiten Maximalwert normierte Softwareanteil und der auf den zweiten Maximalwert normierte Hardwareanteil (10) addiert werden.

14. Verfahren nach einem der Ansprüche 9 bis 13,
**dadurch gekennzeichnet,**
**dass** Schritt a1) zu einem rechenzeitunkritischen Zeitpunkt durchgeführt wird, wobei die Berechnung des auf den zweiten Maximalwert normierten ersten Softwareanteils bei einem Wert zwischen 10 und 40 Prozent des ersten Maximalwerts des Hardwareanteils (10), insbesondere bei 25 Prozent des ersten Maximalwerts des Hardwareanteils (10), durchgeführt wird, und
die Berechnung des auf den zweiten Maximalwert normierten ersten Softwareanteils bei einem Wert zwischen 60 und 90 Prozent des ersten Maximalwerts des Hardwareanteils (10), insbesondere bei 75 Prozent des ersten Maximalwerts des Hardwareanteils (10).

## Claims

1. Digital counter, the dial position being comprised of a hardware part, which determines the n lowest-value bits of the dial position, and at least one software part, which determines the remaining higher-value bits of the dial position,
**characterised in that**
the counter comprises a first and a second software part (12, 14); and that the dial position is comprised of the first software part (12) and the hardware part (10) when the hardware part (10) is in a first counting range, and that the dial position is comprised of the second software part (14) and the hardware part (10) when the hardware part (10) is in a second counting range, wherein the maximum dial position of the hardware part (10) is defined by a maximum value, and the first counting range of the hardware part (10) is essentially defined between the dial positions 0 and half of the maximum value of the hardware part (10) minus 1, and the second counting range is essentially defined between the dial positions of half of the maximum value and the maximum value of the hardware part (10) minus 1 and the change of the respective software part (12, 14) is time-wise separated from the overflow of the hardware part (10).

2. Counter according to claims 1,
**characterised in that**
it comprises a software part-increasing device designed to change the first and the second software part (12, 14) for predeterminable values of the hardware part (10), particularly to effect an increase by the value of 1.

3. Counter according to claim 2,
**characterised in that**
the predeterminable value of the hardware part (10) for increasing the second software part (14) is between 10 and 40 per cent of the maximum value, preferably 25 per cent of the maximum value.

4. Counter according to one of claims 2 or 3,
**characterised in that**
the predeterminable value of the hardware part (10) for increasing the first software part (12) is between 60 and 90 per cent of the maximum value, preferably 75 per cent of the maximum value.

5. Method for operating a digital counter, the dial position being comprised of a hardware part (10), which determines the n lowest-value bits of the dial position, and at least one software part which determines the remaining higher-value bits of the dial position, the counter comprising a first and a second software part (12, 14) and the dial position being made up of the first software part (12) and the hardware part (10) when the hardware part (10) is in a first counting range, and the dial position being made up of the second software part (14) and the hardware part (10) when the hardware part (10) is in a second counting range, wherein the maximum dial position of the hardware part (10) is defined by a maximum value, and the first counting range of the hardware part (10) is essentially defined between the dial positions 0 and half of the maximum value of the hardware part (10) minus 1, and the second counting range is essentially defined between the dial positions of half of the maximum value and the maximum value of the hardware part (10) minus 1 and the change of the respective software part (12, 14) is time-wise separated from the overflow of the hardware part (10).

6. Method according to claim 5,
**characterised in that**
the first software part (12) and the second software part (14) are changed at predeterminable values of the hardware part (10), and are particularly increased by the value of 1.

7. Method according to claim 6,
**characterised in that**
the second software part (14) is changed at a value between 10 and
40 per cent of the maximum value of the hardware part (10), particularly at 25 per cent of the maximum value of the hardware part (10).

8. Method according to claim 6,
**characterised in that**
the first software part (12) is changed at a value between 60 and 90 per cent of the maximum value of the hardware part (10), particularly at 75 per cent of the maximum value of the hardware part (10).

9. Method according to claims 5 to 8,
**characterised in that**
the hardware part (10) is normalised to a first maximum value, and that for normalising the full dial position to a second maximum value different therefrom, the dial position normalised to the second maximum value is being made up of a software part normalised to the second maximum value and a hardware part normalised to the second maximum value.

10. Method according to claim 9,
**characterised in that**
the software part normalised to the second maximum value is calculated by the following step:
a1) Multiplying of the software part valid in each case with the second maximum value.

11. Method according to claim 10,
**characterised in that**
the values for the software parts, which are normalised to the second maximum value, are saved so that they can be used for adding operations within the relevant period of time.

12. Method according to one of claims 9 to 11,
**characterised in that**
the hardware part (10) normalised to the second maximum value is calculated by the following step:
b1) Multiplying by the second maximum value and dividing by the first maximum value, or vice versa.

13. Method according to one of claims 9 to 12,
**characterised in that**
for calculating the dial position normalised to the second maximum value, the software part normalised to the second maximum value and the hardware part (10) normalised to the second maximum value are added.

14. Method according to one of claims 9 to 13,
**characterised in that**
step a1) is executed at a non-computation-time-critical point in time, the calculation of the first software part normalised to the second maximum value being performed at a value between 10 and 40 per cent of the first maximum value of the hardware part (10), particularly at 25 per cent of the first maximum value of the hardware part (10), and
the calculation of the first software part normalised to the second maximum value being performed at a value between 60 and 90 per cent of the first maximum value of the hardware part (10), particularly at 75 per cent of the first maximum value of the hardware part (10).

## Revendications

1. Compteur numérique dont l'état de compteur se compose d'une composante matérielle qui détermine les n bits de poids faible de l'état du compteur et, d'au moins, une composante logicielle qui détermine le reste des bits de poids plus fort de l'état du compteur,
**caractérisé en ce que**
le compteur comprend une première et une deuxième composante logicielle (12, 14) ; et l'état du compteur est composé de la première composante logicielle (12) et de la composante matérielle (10), lorsque la composante matérielle (10) figure dans un premier domaine de comptage, et que l'état du compteur est composé de la deuxième composante logicielle (14) et de la composante matérielle (10) lorsque la composante matérielle (10) figure dans un deuxième domaine de comptage, l'état maximal du compteur de la composante matérielle (10) étant défini par une valeur maximale et le premier domaine de comptage de la composante matérielle (10) étant défini, pour l'essentiel, entre les états du compteur 0 et la moitié de la valeur maximale de la composante matérielle (10) moins 1 et le deuxième domaine de comptage, pour l'essentiel, entre les états du compteur de la moitié de la valeur maximale et la valeur maximale de la composante matérielle (10) moins 1, et les modifications de la composante logicielle (12, 14) correspondante étant séparées, par le temps, du débordement de la composante matérielle (10).

2. Compteur selon la revendication 1,
**caractérisé en ce que**
il comprend un dispositif d'augmentation de composante logicielle, conçu de façon à modifier la première et la deuxième composante logicielle (12, 14) pour des valeurs prescriptibles de la composante matérielle (10), en particulier pour augmenter la valeur 1.

3. Compteur selon la revendication 2,
**caractérisé en ce que**
la valeur prescriptible de la composante matérielle (10) pour l'augmentation de la deuxième composante logicielle (14) est comprise entre 10 et 40 pour cent de la valeur maximale, de préférence 25 pour cent de la valeur maximale.

4. Compteur selon l'une quelconque des revendications 2 ou 3,
**caractérisé en ce que**
la valeur prescriptible de la composante matérielle (10) pour l'augmentation de la première composante logicielle (12) est comprise entre 60 et 90 pour cent de la valeur maximale, de préférence 75 pour cent de la valeur maximale.

5. Procédé d'exploitation d'un compteur numérique, l'état du compteur numérique se composant d'une composante matérielle (10) qui détermine les n bits de poids le plus faible de l'état du compteur, et d'au moins une composante logicielle, qui détermine le reste des bits de poids plus fort de l'état du compteur, le compteur comprenant une première et une deuxième composante logicielle (12, 14) et l'état du compteur étant composé de la première composante logicielle (12) et de la composante matérielle (10), lorsque la composante matérielle (10) figure dans un premier domaine de comptage, et que l'état du compteur est composé de la deuxième composante logicielle (14) et de la composante matérielle (10) lorsque la composante matérielle (10) figure dans un deuxième domaine de comptage, l'état maximal du compteur de la composante matérielle (10) étant défini par une valeur maximale et le premier domaine de comptage de la composante matérielle (10) étant défini, pour l'essentiel, entre les états du compteur 0 et la moitié de la valeur maximale de la composante matérielle (10) moins 1, et le deuxième domaine de comptage, pour l'essentiel, entre les états du compteur de la moitié de la valeur maximale et la valeur maximale de la composante matérielle (10) moins 1, et les modifications de la composante logicielle (12, 14) correspondante étant séparées, par le temps, du débordement de la composante matérielle (10).

6. Procédé selon la revendication 5,
**caractérisé en ce que**
la première composante logicielle (12) et la deuxième composante logicielle (14) sont modifiées pour des valeurs prescriptibles de composantes matérielles (10), en particulier sont augmentées de la valeur 1.

7. Procédé selon la revendication 6,
**caractérisé en ce que**
la deuxième composante logicielle (14) est modifiée pour une valeur comprise entre 10 et 40 pour cent de la valeur maximale de la composante matérielle (10), en particulier pour 25 pour cent de la valeur maximale de la composante matérielle (10).

8. Procédé selon la revendication 6,
**caractérisé en ce que**
la première composante logicielle (12) est modifiée pour une valeur comprise entre 60 et 90 pour cent de la valeur maximale de la composante matérielle (10), en particulier pour 75 pour cent de la valeur maximale de la composante matérielle (10).

9. Procédé selon l'une quelconque des revendications 5 à 8,
**caractérisé en ce que**
la composante matérielle (10) est normalisée d'après une première valeur maximale et, pour normalisation de la totalité de l'état du compteur d'après une deuxième valeur maximale qui est différente de l'état de compteur normalisé d'après la deuxième valeur maximale, est composée d'une composante logicielle normalisée d'après la deuxième valeur maximale et d'une composante matérielle normalisée d'après la deuxième valeur maximale.

10. Procédé selon la revendication 9,
**caractérisé en ce que**
la composante logicielle normalisée d'après la deuxième valeur maximale est calculée par l'étape suivante :
a1) multiplication de la composante logicielle actuellement valide par la deuxième valeur maximale.

11. Procédé selon la revendication 10,
**caractérisé en ce que**
les valeurs des composantes logicielles normalisées d'après la deuxième valeur maximale sont sauvegardées, si bien qu'elles peuvent être utilisées pour des additions pendant la durée correspondante.

12. Procédé selon l'une quelconque des revendications 9 à 11,
**caractérisé en ce que**
la composante matérielle (10) normalisée d'après la deuxième valeur maximale est calculée par l'étape suivante :
b1) multiplication par la deuxième valeur maximale et division par la première valeur maximale ou l'inverse.

13. Procédé selon l'une quelconque des revendications 9 à 12,
**caractérisé en ce que**
pour le calcul de l'état du compteur normalisé d'après la première valeur maximale, la composante logicielle normalisée d'après la deuxième valeur maximale et la composante matérielle (10) normalisée d'après la deuxième valeur maximale sont additionnées.

14. Procédé selon l'une quelconque des revendications 9 à 13,
**caractérisé en ce que**
l'étape a1) est réalisée en un instant non critique de temps de calcul, le calcul de la première composante logicielle normalisée d'après la deuxième valeur maximale étant réalisé pour une valeur entre 10 et 40 pour cent de la première valeur maximale de la composante matérielle (10), en particulier pour 25 pour cent de la première valeur maximale de la composante matérielle (10), et le calcul de la première composante logicielle normalisée d'après la deuxième valeur maximale entre 60 et 90 pour cent de la première valeur maximale de la composante matérielle (10), en particulier pour 75 pour cent de la première valeur maximale de la composante matérielle (10).
